# EUROPÄISCHE PATENTSCHRIFT

(11) **EP 3 291 653 B1**
(45) Veröffentlichungstag und Bekanntmachung des Hinweises auf die Patenterteilung: **02.08.2023**
(21) Anmeldenummer: 17170338.2
(22) Anmeldetag: 10.05.2017
(51) Int. Cl.: H05K 1/02, H05K 5/00, H01R 12/71, H05K 1/11, H05K 3/32

(54) **STEUERMODUL FÜR EIN FAHRZEUG**
CONTROL MODULE FOR A VEHICLE
MODULE DE COMMANDE POUR UN VÉHICULE AUTOMOBILE

(30) Priorität: 29.08.2016 DE 102016216138
(43) Veröffentlichungstag der Anmeldung: 07.03.2018
(73) Patentinhaber: Robert Bosch GmbH, 70442 Stuttgart (DE)
(72) Erfinder: Zweigle, Peter, 71254 Ditzingen (DE)

(56) Entgegenhaltungen:
- EP-A1- 2 373 136
- DE-A1- 19 757 938
- DE-A1-102006 052 211
- DE-A1-102010 030 170

## Beschreibung

### Gebiet der Erfindung

Die Erfindung betrifft eine Anordnung mit wenigstens einem Aktuator und einem Steuermodul für ein Fahrzeug.

### Stand der Technik

Die elektrische Kontaktierung von Aktuatoren eines Automatikgetriebes zu deren Steuermodul ist häufig als Federkontaktpaar ausgeführt. Späne im Getriebeöl können zu Kurzschlüssen zwischen den beiden Federkontakten oder den zugehörigen Kontaktflächen bzw. zu nahe gelegenen Metallbauteilen führen. Um dies zu verhindern, ist der Kontaktbereich an den kritischen Seiten mit Schutzwänden umgeben, die üblicherweise am Aktuator angebracht sind. Wenn die Kontaktflächen direkt auf einer Leiterplattenoberfläche liegen, müssen in der Leiterplatte entsprechende Aussparungen vorgesehen werden, in die die Schutzwände eingesteckt werden, um die nötige Überlappungshöhe zu erreichen und eine Labyrinthwirkung zu erzielen.

Die Aussparungen in der Leiterplatte können dann unerwünscht sein, wenn auf der gegenüberliegenden Seite der Leiterplatte elektronische Komponenten bestückt sind, die mit der sogenannten Dam-and-Fill-Vergussmethode gegen Umwelteinflüsse geschützt werden. Beim Dam-and-Fill-Verfahren wird zunächst ein Damm aus einem hochviskosen Material um die elektronischen Komponenten erzeugt, und die entstehende Wanne wird mit einer wesentlich weniger viskosen Vergussmasse aufgefüllt.

Um zu verhindern, dass die dünnflüssige Vergussmasse in die Aussparung fließt, muss der Damm um diese herum gelegt werden, wodurch Bestückungsfläche verloren gehen kann.

Die DE 10 2010 030 170 A1 zeigt ein Steuergerät, bei dem auf einem Schaltungsträger ein Rahmen angeordnet ist, so dass sich eine Wanne bildet, die mit einer Moldmasse aufgefüllt wird.

Die DE 44 05 710 A1 zeigt eine Trägerplatte mit Bauelementen, die mit einem Ring umgeben werden, in den ein Gel gefüllt wird.

### Offenbarung der Erfindung

### Vorteile der Erfindung

Ausführungsformen der vorliegenden Erfindung können in vorteilhafter Weise ermöglichen, ein kompaktes, leicht herzustellendes und kostengünstiges Steuermodul mit gutem Spanschutz bereitzustellen.

Ideen zu Ausführungsformen der vorliegenden Erfindung können unter anderem als auf den nachfolgend beschriebenen Gedanken und Erkenntnissen beruhend angesehen werden.

Die Erfindung betrifft eine Anordnung mit wenigstens einem Aktuator und einem Steuermodul nach Anspruch 1 für ein Gerät eines Fahrzeugs. Ein Steuermodul kann eine Leiterplatte mit elektronischen Komponenten zum Steuern des Geräts umfassen, das beispielsweise ein Getriebe bzw. ein Automatikgetriebe sein kann. Neben den elektronischen Komponenten, die eine Steuerschaltung bilden können, kann das Steuermodul elektrische Anschlüsse und/oder Sensoren umfassen.

Das Steuermodul kann an dem Gerät angebracht sein und auch mit diesem elektrisch verbunden sein. Das Fahrzeug kann ein Pkw, Lkw oder Bus sein.

Gemäß der Erfindung umfasst das Steuermodul eine Leiterplatte, die elektronische Komponenten zum Steuern des Aktuators trägt. Die Leiterplatte kann glasfaserverstärkten Kunststoff umfassen. Die elektronischen Komponenten können Widerstände, Kondensatoren, Halbleiterschaltelemente und/oder integrierte Schaltkreise umfassen. Der Aktuator kann einen Magneten umfassen, der beispielsweise mechanische Komponenten des Geräts bewegen kann.

Weiter umfasst das Steuermodul einen auf die Leiterplatte aufgetragenen Damm, der die elektronischen Komponenten umgibt, und eine Vergussmasse, in die die elektronischen Komponenten eingebettet sind und die innerhalb des Damms vergossen ist. Die elektronischen Komponenten können mit dem Dam-and-Fill-Verfahren eingegossen sein.

Weiter umfasst das Steuermodul elektrische Kontaktflächen für den wenigstens einen Aktuator, die auf einer Rückseite der Leiterplatte angeordnet sind, die einer Vorderseite mit dem Damm und der Vergussmasse gegenüberliegt. Die elektrischen Kontaktflächen können von Leiterbahnen der Leiterplatte bereitgestellt sein und/oder beispielsweise von der Leiterplatte bereitgestellte Kupferpads sein. Auf diese Kontaktflächen können Kontaktfedern des Aktuators abgesetzt werden, um einen elektrischen Kontakt herzustellen. Es ist zu verstehen, dass die Begriffe Vorderseite und Rückseite lediglich die zwei gegenüberliegenden Seiten der Leiterplatte bezeichnen, aber nicht deren Orientierung im Raum beschreiben müssen.

Weiter umfasst das Steuermodul eine durch die Leiterplatte verlaufende Öffnung bzw. Aussparung, die zwischen den elektrischen Kontaktflächen verläuft, wobei in die Öffnung ein Spanschutzelement gesteckt ist, das auf der Rückseite der Leiterplatte hervorragt und eine Trennwand zwischen den Kontaktflächen bereitstellt. In die Öffnung, die beispielsweise durch Bohren oder Ausstanzen erzeugt werden kann, ist ein Spanschutzelement eingesteckt und/oder eingepresst, das eine Trennwand bereitstellt, die zwischen den Kontaktflächen von der Leiterplatte abragt. Die Trennwand kann die Kontaktflächen vor Spänen schützen, die die elektrischen Kontaktflächen und/oder die Kontaktfedern kurzschließen könnten. Insbesondere ist die Trennwand nicht am Aktuator angebracht, sondern an der Leiterplatte des Steuermoduls.

Das Spanschutzelement kann ein Kunststoffelement sein, das einstückig, beispielsweise als Spritzgussteil, hergestellt sein kann. Das Spanschutzelement kann von oben, d.h. von der Vorderseite aus, in die Leiterplatte bestückt werden. Dies kann den Vorteil aufweisen, dass das Spanschutzelement wie die anderen elektronischen Komponenten von oben bestückt werden kann und das Steuermodul während seiner Herstellung nicht gewendet werden muss. Außerdem kann Bestückungsfläche gewonnen werden, da der Damm und die Vergussmasse nahe am Rand der Leiterplatte verlaufen können. Damit kann auch eine Prozesszeit zum Aufbringen des Damms auf die Leiterplatte verkürzt werden.

Gemäß der Erfindung ist das Spanschutzelement auf der Vorderseite der Leiterplatte zumindest teilweise in die Vergussmasse eingegossen. Nach dem Einstecken und/oder Einpressen in die Leiterplatte kann das Spanschutzelement durch teilweises oder ganzes Vergießen mit der Vergussmasse in der Leiterplatte fixiert werden.

Gemäß einer Ausführungsform der Erfindung ragt das Spanschutzelement aus der Vergussmasse heraus. Auf der Vorderseite kann das Spanschutzelement nur teilweise in die Vergussmasse eingegossen sein.

Gemäß einer Ausführungsform der Erfindung ist das Spanschutzelement auf der Vorderseite vollständig von der Vergussmasse bedeckt. Auf diese Weise kann auch das Innere des Spanschutzelements, wenn dieses hohl ist, mit der beim Vergießen noch flüssigen Vergussmasse aufgefüllt werden.

Gemäß der Erfindung ist das Spanschutzelement hohl und weist einen Hohlraum auf, der durch die Leiterplatte führt. Auf diese Weise kann das Spanschutzelement im Bereich der Leiterplatte elastisch ausgeführt sein. Die Öffnung in der Leiterplatte kann durch das Spanschutzelement abgedichtet werden, da das Spanschutzelement in diesem Bereich dünnwandig und mit Übermaß ausgeführt sein kann.

Wie bereits oben beschrieben, kann der Hohlraum mit Vergussmasse gefüllt sein. Auf diese Weise kann das Spanschutzelement nach dem Vergießen nicht mehr zusammenziehen und die Öffnung bleibt durch das Spanschutzelement abgedichtet.

Gemäß der Erfindung weist das Spanschutzelement einen Halterand auf, der ein Fallen des Spanschutzelements durch die Öffnung verhindert. Der Halterand ist auf der Vorderseite der Leiterplatte abgesetzt. Der Halterand kann ein Bereich des Spanschutzelements sein, der breiter ist als die Öffnung in der Leiterplatte.

Gemäß einer Ausführungsform der Erfindung weist das Spanschutzelement einen Hinterschnitt auf, der auf der Rückseite der Leiterplatte abgesetzt ist. Beispielsweise kann das Spanschutzelement bis zum Halterand auf Anschlag in die Leiterplatte eingepresst werden und durch den Hinterschnitt, der von dem Spanschutzelement umlaufend abstehen kann, auf Rückseite fixiert werden.

Weist das Spanschutzelement einen Hohlraum im Bereich des Hinterschnitts auf, kann der Hinterschnitt leicht durch die Öffnung geschoben werden, da das Spanschutzelement in diesem Bereich leicht verformt werden kann. Ein anschließendes Füllen des Spanschutzelements mit Vergussmasse kann ein späteres Verformen erschweren und den Hinterschnitt vor der Öffnung fixieren.

Gemäß einer Ausführungsform der Erfindung weist das Spanschutzelement einen Vorsprung auf, der das Spanschutzelement in der Vergussmasse hält. Eine weitere Möglichkeit, das Spanschutzelement in der Vergussmasse zu fixieren, ist ein Vorsprung, der beispielsweise breiter sein kann als andere in der Vergussmasse befindliche Bereiche des Spanschutzelements und/oder der von dem Spanschutzelement abstehen kann.

Gemäß einer Ausführungsform der Erfindung weist das Spanschutzelement einen Fixierrand auf, der mit der Rückseite der Leiterplatte fluchtet. Die von dem Spanschutzelement bereitgestellte Trennwand kann schmaler sein als die Öffnung in der Leiterplatte. Der Fixierrand kann beim Einstecken des Spanschutzelements auf einem Werkzeug abgesetzt werden, das mit der Rückseite der Leiterplatte fluchtet. Auf diese Weise kann das Spanschutzelement auf eine durch die Einpressanlage bestimmte Höhe eingesteckt bzw. eingepresst werden. Die Toleranz zwischen dem Spanschutzelement und der Vorderseite der Leiterplatte kann durch die Vergussmasse ausgeglichen werden. Damit kann das Spanschutzelement dazu genutzt werden, den Kontaktbereich mit den Kontaktflächen mechanisch gegen die Federkraft der Kontaktfedern des Aktuators abzustützen, ohne dass dies durch eine Dickentoleranz der Leiterplatte beeinflusst wird.

Gemäß einer Ausführungsform der Erfindung sind das Spanschutzelement und die Öffnung in der Leiterplatte für jeweils zwei elektrische Kontaktflächen T-förmig geformt. Die Trennwand kann zwischen zwei Kontaktflächen und seitlich entlang der Kontaktflächen verlaufen. Die Trennwand kann dazu dienen, zwei benachbarte Kontaktflächen voneinander zu trennen und/oder eine Kontaktfläche von einem weiteren Potential abzutrennen.

Gemäß einer Ausführungsform der Erfindung umfasst die Anordnung einen Aktuator, der wenigstens zwei Kontaktfedern aufweist, die auf wenigstens zwei Kontaktflächen aufgepresst sind, so dass die Trennwand zumindest teilweise zwischen den Kontaktfedern verläuft. Der Aktuator kann weiter Schutzwände aufweisen, die die Kontaktfedern zumindest teilweise umgeben und die in Richtung der Leiterplatte weisen. Die Schutzwände des Aktuators können entlang, beispielsweise im Wesentlichen parallel zu der Trennwand für die wenigstens zwei Kontaktflächen verlaufen. Auf diese Weise wird durch die Trennwand und eine Schutzwand ein Labyrinth gebildet. Die Spanschutzwirkung wird durch die Labyrinthwirkung zwischen der Trennwand auf der Leiterplatte und der Schutzwand am Aktuator verbessert.

Kurze Beschreibung der Zeichnungen Nachfolgend werden Ausführungsformen der Erfindung unter Bezugnahme auf die beigefügten Zeichnungen beschrieben.
Fig. 1 zeigt eine perspektivische Ansicht eines Steuermoduls gemäß einer Ausführungsform der Erfindung.
Fig. 2 zeigt eine perspektivische Teilansicht von Komponenten des Steuermoduls aus der Fig. 1.
Fig. 3 zeigt einen schematischen Querschnitt durch ein Spanschutzelement für ein Steuermodul gemäß einer weiteren Ausführungsform der Erfindung.
Fig. 4 zeigt einen schematischen Querschnitt durch ein Steuermodul gemäß einer weiteren Ausführungsform der Erfindung.
Fig. 5 zeigt einen schematischen Querschnitt durch ein Steuermodul gemäß einer weiteren Ausführungsform der Erfindung.
Fig. 6 zeigt einen schematischen Querschnitt durch ein Steuermodul gemäß einer weiteren Ausführungsform der Erfindung.
Fig. 7 zeigt eine perspektivische Ansicht eines Aktuators für ein Steuermodul gemäß einer Ausführungsform der Erfindung.
Fig. 8 zeigt eine perspektivische Ansicht eines Steuermoduls gemäß einer weiteren Ausführungsform der Erfindung.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

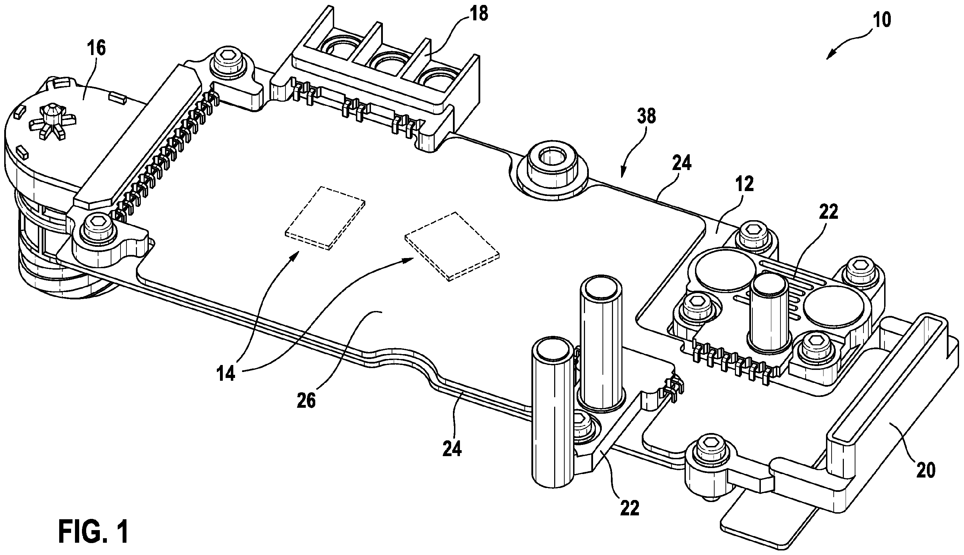

Fig. 1 zeigt ein Getriebesteuermodul 10, das eine Leiterplatte 12 und darauf befindliche elektronische Komponenten 14 umfasst. An der Leiterplatte 12 können noch weitere Komponenten des Steuermoduls 10 befestigt sein, wie etwa ein Leistungsanschluss 16, weitere Anschlüsse 18, eine Steckerleiste 20, Drucksensoren 22 usw.

Die elektronischen Komponenten 14 sind von einem Damm 24 umgeben, der abschnittsweise am Rand der Leiterplatte 12 verläuft und der mit der Leiterplatte 12 zusammen eine Wanne bildet, in der die elektronischen Komponenten 14 in eine Vergussmasse 26 eingebettet sind.

Wie in der Fig. 1 zu erkennen ist, sind die elektronischen Komponenten 14 vollständig von der Vergussmasse 26 umgeben. Weiter ragen aus der Vergussmasse 26 Leiter hervor, die mit den Anschlüssen 16, 18, 20 und den Sensoren 22 verbunden sind.

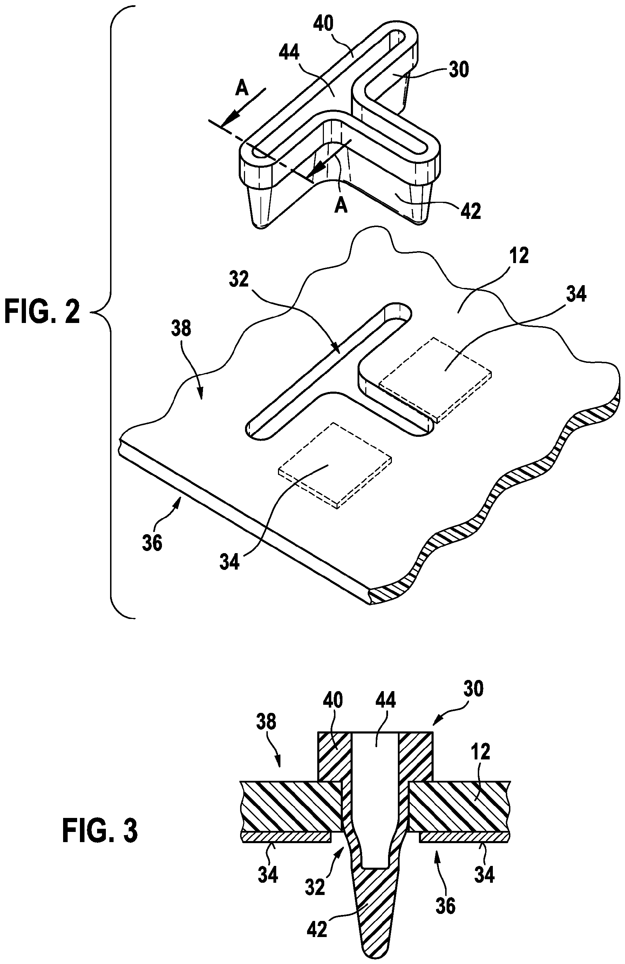

Die Fig. 2 zeigt die Leiterplatte 12 und ein Spanschutzelement 30, bevor es in eine Öffnung 32 in der Leiterplatte gesteckt ist. Die Fig. 3 zeigt einen Querschnitt entlang der Linie A-A in der Fig. 2, wobei das Spanschutzelement 30 in die Öffnung 32 gesteckt wurde.

Die Öffnung 32 ist neben und zwischen zwei Kontaktflächen 34 angebracht, die auf einer Rückseite 36 der Leiterplatte 12 angebracht sind. Die Rückseite 36 liegt der Vorderseite 38 gegenüber, auf der die elektrischen Komponenten 14, der Damm 24 und die Vergussmasse 26 angebracht sind.

Die Kontaktflächen 34 können als Metallschicht auf der Leiterplatte 12 ausgebildet sein. Die beiden Kontaktflächen 34 bilden ein Paar von Anschlüssen für einen Aktuator, der von dem Steuermodul 10 angesteuert wird. Die Kontaktflächen 34 sind durch die Leiterplatte 12 hindurch mit den elektronischen Komponenten 14 elektrisch verbunden.

Die Öffnung 32 und das Spanschutzelement 30 sind im Wesentlichen T-förmig, wobei das Spanschutzelement in einem Mittelbereich einen derartigen Querschnitt aufweist, dass es die Öffnung dicht verschließen kann. In einem oberen Bereich weist das Spanschutzelement 30 einen Halterand 40 auf, mit dem das Spanschutzelement 30 auf der Vorderseite 38 der Leiterplatte 12 abgestützt ist. In einem unteren Bereich weist das Spanschutzelement eine Trennwand 42 auf, die von der Rückseite 36 der Leiterplatte 12 zwischen und neben den Kontaktflächen 34 abragt.

Im Inneren und insbesondere im mittleren Bereich ist das Spanschutzelement 30 hohl und weist einen T-förmigen Hohlraum 44 auf. Damit ist das Spanschutzelement 30 in diesem Bereich elastisch und kann in die Öffnung 32 gedrückt werden und/oder diese abdichten.

In Bezug auf die Fig. 1 liegt die Öffnung 32 (von der normalerweise mehrere vorhanden sind) innerhalb des Damms 24. Nachdem das Spanschutzelement 30 in die Öffnung 32 verbaut wurde, wird das Spanschutzelement 30 teilweise oder vollständig in die Vergussmasse 26 eingegossen. Die Spanschutzelemente 30 sind daher in der Fig. 1 nicht mehr sichtbar.

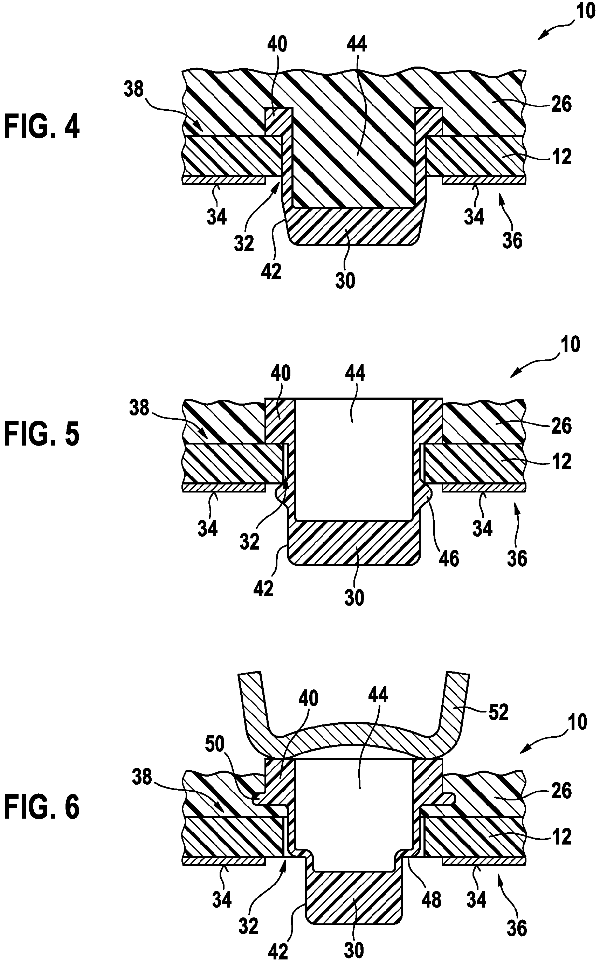

Die Fig. 4 zeigt eine weitere Ausführungsform eines Steuermoduls 10, bei der das Spanschutzelement 30 vollständig in die Vergussmasse 26 eingegossen wurde. Dabei wurde auch der Hohlraum 44 mit Vergussmasse 26 befüllt.

Bei der Fig. 5 wurde das Spanschutzelement 30 nur teilweise in die Vergussmasse 26 eingegossen und der Halterand 40 ragt über die Vergussmasse 26 hinaus. Der Hohlraum 44 wurde nicht mit Vergussmasse 26 gefüllt. Weiter ist in der Fig. 5 an dem Spanschutzelement 30 ein Hinterschnitt 46 bzw. umlaufender Vorsprung 46 angebracht, mit dem das Spanschutzelement an der Leiterplatte 12 fixiert werden kann. Der Hinterschnitt 46 ragt auf der Seite der Trennwand 42 über eine Breite der Trennwand 42 hinaus und/oder ist breiter als die Öffnung 32. Durch den Hohlraum 44 kann der Hinterschnitt 46 durch die Öffnung geschoben werden, wobei er sich anschließend in der Öffnung 32 verklemmt.

Die Fig. 6 zeigt eine weitere Ausführungsform, bei der der Halterand 40, der eine Breite größer als die Öffnung 32 aufweist, nicht auf der Vorderseite 38 abgesetzt ist, sondern die Einsteck- bzw. Einpresstiefe des Spanschutzelements 30 mit einem Fixierrand 48 an der Rückseite festgelegt wurde. Dazu kann das Spanschutzelement 30 vor dem Vergießen mit dem Fixierrand 48 auf einem Werkzeug abgestützt werden, so dass der Fixierrand 48 mit der Rückseite 36 der Leiterplatte 12 fluchtet und dann das Spanschutzelement 30 in die Vergussmasse 26 eingegossen wird, um es letztendlich an der Leiterplatte 12 zu fixieren.

An dem Halterand 40 kann auch ein umlaufender Vorsprung 50 angebracht sein, der von dem Halterand 40 absteht, der das Spanschutzelement 30 in der Vergussmasse 26 fixiert, falls diese das Spanschutzelement 30 nicht reibend oder klebend halten kann.

Durch das Festlegen einer Einstecktiefe des Spanschutzelements 30 kann das Spanschutzelement 30 bzw. der Halterand 40 auch zum Abstützen der Kontaktflächen 34 gegenüber der Federkraft von Kontaktfedern, die gegen die Kontaktflächen 34 drücken, verwendet werden. Dazu kann eine Abstützung 52 auf den Halterand 40 abgestützt werden.

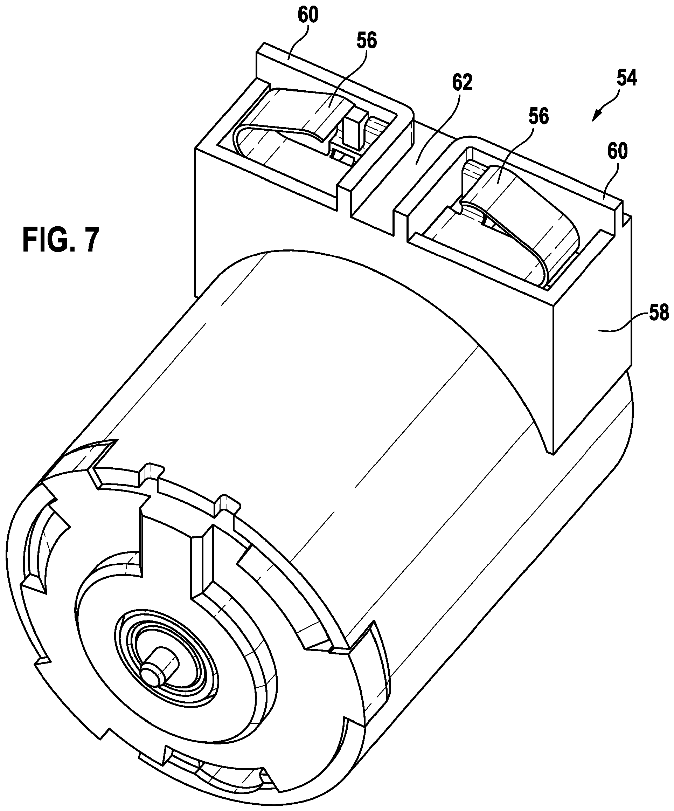

Die Fig. 7 zeigt einen Aktuator 54 für ein Steuermodul 10, der elektrisch mit dem Steuermodul 10 über die Kontaktflächen 34 verbunden wird. Dazu weist der Aktuator 54, beispielsweise ein Magnet, zwei Kontaktfedern 56 auf, die von dem Aktuator 54 abstehen. Die Kontaktfedern 56 werden auf die Kontaktflächen 34 gepresst, wenn der Aktuator 54 über der Rückseite 36 der Leiterplatte 12 platziert wird.

Jede der Kontaktfedern 56 ist von einem Gehäuseelement 58 umgeben, das die Kontaktfedern 56 kastenförmig umschließt. Auf dem Gehäuseelement 58 befinden sich zwei L-förmige Schutzwände 60, die abschnittsweise zwischen den Kontaktfedern 56 verlaufen. Die beiden L-förmigen Schutzwände 60 und das Gehäuseelement 58 bilden zwischen den Kontaktfedern 56 einen Kanal 62.

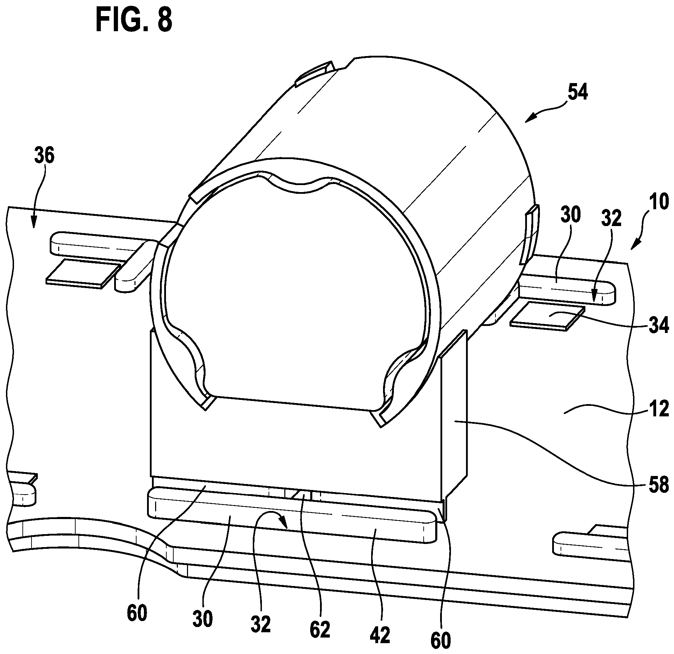

Die Fig. 8 zeigt den über der Leiterplatte 12 fixierten Aktuator 54. Dabei ist zu erkennen, wie die Trennwände 42 von Spanschutzelementen 30 aus Öffnungen 32 in der Leiterplatte 12 hervorragen.

Die Schutzwände 60 des Aktuators 54 berühren dabei nicht die Oberfläche der Leiterplatte 12. Genauso berührt die zugehörige Trennwand 42 nicht das Gehäuseelement 58 des Aktuators 32. Der Abschnitt der Trennwand 42, der zwischen den Kontaktflächen 34 verläuft, ist in dem Kanal 62 aufgenommen und bildet mit den korrespondierenden Abschnitten der Schutzwände 42 ein Labyrinth, das eine Kontaktierung der Leiter unterhalb des Aktuators 54 miteinander durch Späne verhindert. Die Abschnitte der Trennwände 42, die neben den Kontaktflächen 34 verlaufen, verlaufen im Wesentlichen parallel zu weiteren Abschnitten der Schutzwände 60 und bilden ein weiteres Labyrinth, das verhindert, dass diese Leiter mit einem Leiter, beispielsweise neben dem Rand der Leiterplatte 12, durch Späne kontaktiert werden.

## Patentansprüche

1. Anordnung mit wenigstens einem Aktuator (54) und einem Steuermodul (10) für ein Fahrzeug, das Steuermodul (10) umfassend:
eine Leiterplatte (12), die elektronische Komponenten (14) zum Steuern des wenigstens eines Aktuators (54) trägt,
einen auf die Leiterplatte (12) aufgetragenen Damm (24), der die elektronischen Komponenten (14) umgibt;
eine Vergussmasse (26), in die die elektronischen Komponenten (14) eingebettet sind und die innerhalb des Damms (24) vergossen ist;
elektrische Kontaktflächen (34) für den wenigstens einen Aktuator (54), **dadurch gekennzeichnet, dass** die Kontaktflächen (34) auf einer Rückseite (36) der Leiterplatte (12) angeordnet sind, die einer Vorderseite (38) mit dem Damm (24) und der Vergussmasse (26) gegenüberliegt, und dass eine durch die Leiterplatte (12) verlaufende Öffnung (32) zwischen den elektrischen Kontaktflächen (34) verläuft;
wobei in die Öffnung (32) ein Spanschutzelement (30) gesteckt ist, das auf der Rückseite (36) der Leiterplatte (12) hervorragt und eine Trennwand (42) zwischen den Kontaktflächen (34) bereitstellt; wobei das Spanschutzelement (30) einen Halterand (40) aufweist, der auf der Vorderseite (38) der Leiterplatte (12) abgesetzt ist und ein vollständiges Stecken des Spanschutzelementes (30) durch die Öffnung (32) verhindert, wobei das Spanschutzelement (30) hohl ist und einen Hohlraum (44) aufweist, der durch die Leiterplatte (12) führt, wobei das Spanschutzelement (30) in einem Mittelbereich einen derartigen Querschnitt aufweist, dass es die Öffnung (32) dicht verschließt; wobei das Spanschutzelement (30) auf der Vorderseite (38) der Leiterplatte (12) zumindest teilweise in die Vergussmasse (26) eingegossen ist; und wobei der wenigstens eine Aktuator (54) über der Rückseite (36) der Leiterplatte (12) platziert ist und
wenigstens zwei Kontaktfedern (56) aufweist, die auf die wenigstens zwei Kontaktflächen (34) aufgepresst sind, so dass die Trennwand (42) zumindest teilweise zwischen den Kontaktfedern (56) verläuft.

2. Anordnung nach Anspruch 1,
wobei das Spanschutzelement (30) aus der Vergussmasse (26) herausragt; oder
wobei das Spanschutzelement (30) auf der Vorderseite (38) vollständig von der Vergussmasse (26) bedeckt ist.

3. Anordnung nach einem der vorhergehenden Ansprüche,
wobei der Hohlraum (44) mit Vergussmasse (26) gefüllt ist.

4. Anordnung nach einem der vorhergehenden Ansprüche,
wobei das Spanschutzelement (30) einen Hinterschnitt (46) aufweist, der auf der Rückseite (36) der Leiterplatte (12) abgesetzt ist.

5. Anordnung nach einem der vorhergehenden Ansprüche,
wobei das Spanschutzelement (30) einen Vorsprung (50) aufweist, der das Spanschutzelement (30) in der Vergussmasse (26) hält.

6. Anordnung nach einem der vorhergehenden Ansprüche, wobei das Spanschutzelement (30) und die Öffnung (32) in der Leiterplatte (12) für jeweils zwei elektrische Kontaktflächen (34) T-förmig geformt sind.

## Claims

1. Arrangement having at least one actuator (54) and a control module (10) for a vehicle, the control module (10) comprising:
a printed circuit board (12) which bears electronic components (14) for controlling the at least one actuator (54) ;
a dam (24) which is applied to the printed circuit board (12) and surrounds the electronic components (14);
a potting compound (26) in which the electronic components (14) are embedded and which has been poured within the dam (24);
electrical contact surfaces (34) for the at least one actuator (54), **characterized in that** the contact surfaces (34) are arranged on a rear side (36) of the printed circuit board (12), which lies opposite a front side (38) having the dam (24) and the potting compound (26), and **in that** an opening (32) passing through the printed circuit board (12) runs between the electrical contact surfaces (34);
wherein a swarf protection element (30) is inserted in the opening (32), protrudes on the rear side (36) of the printed circuit board (12) and provides a partition (42) between the contact surfaces (34); wherein the swarf protection element (30) has a retaining edge (40) which is offset on the front side (38) of the printed circuit board (12) and prevents the swarf protection element (30) from being completely inserted through the opening (32), wherein the swarf protection element (30) is hollow and has a cavity (44) which is routed through the printed circuit board (12), wherein a middle region of the swarf protection element (30) has a cross section such that said swarf protection element tightly seals the opening (32); wherein at least part of the swarf protection element (30) is encapsulated in the potting compound (26) on the front side (38) of the printed circuit board (12);
and wherein the at least one actuator (54) is placed over the rear side (36) of the printed circuit board (12) and has at least two contact springs (56) which are pressed against the at least two contact surfaces (34), with the result that at least part of the partition (42) runs between the contact springs (56).

2. Arrangement according to Claim 1,
wherein the swarf protection element (30) protrudes from the potting compound (26); or
wherein the swarf protection element (30) is completely covered by the potting compound (26) on the front side (38) .

3. Arrangement according to either of the preceding claims,
wherein the cavity (44) is filled with potting compound (26) .

4. Arrangement according to one of the preceding claims, wherein the swarf protection element (30) has an undercut (46) which is offset on the rear side (36) of the printed circuit board (12).

5. Arrangement according to one of the preceding claims, wherein the swarf protection element (30) has a projection (50) which retains the swarf protection element (30) in the potting compound (26).

6. Arrangement according to one of the preceding claims, wherein the swarf protection element (30) and the opening (32) in the printed circuit board (12) are formed in the shape of a T for two electrical contact surfaces (34) in each case.

## Revendications

1. Ensemble comprenant au moins un actionneur (54) et un module de commande (10), ledit ensemble étant destiné à un véhicule, le module de commande (10) comprenant :
une carte de circuit imprimé (12) qui porte des composants électroniques (14) destinés à commander l'au moins un actionneur (54),
un barrage (24) qui est appliqué sur la carte de circuit imprimé (12) et qui entoure les composants électroniques (14) ;
une matière de coulée (26) dans laquelle les composants électroniques (14) sont incorporés et qui est coulée à l'intérieur du barrage (24) ;
des surfaces de contact électrique (34) destinées à l'au moins un actionneur (54),
**caractérisé en ce que** les surfaces de contact (34) sont disposées sur un côté arrière (36) de la carte de circuit imprimé (12) qui est opposé à un côté avant (38) pourvu du barrage (24) et de la matière de coulée (26) et **en ce qu'**une ouverture (32), s'étendant à travers la carte de circuit imprimé (12), s'étend entre les surfaces de contact électrique (34) ;
un élément de protection contre les copeaux (30) étant inséré dans l'ouverture (32) et faisant saillie sur le côté arrière (36) de la carte de circuit imprimé (12) et fournissant une paroi de séparation (42) entre les surfaces de contact (34) ; l'élément de protection contre les copeaux (30) comportant un bord de retenue (40) qui est décalé sur le côté avant (38) de la carte de circuit imprimé (12) et empêchant l'élément de protection contre les copeaux (30) d'être complètement enfiché à travers l'ouverture (32), l'élément de protection contre les copeaux (30) étant creux et comportant une cavité (44) qui traverse la carte de circuit imprimé (12), l'élément de protection contre les copeaux (30) ayant dans une région centrale une section transversale permettant de fermer hermétiquement l'ouverture (32) ; l'élément de protection contre les copeaux (30) situé sur le côté avant (38) de la carte de circuit imprimé (12) étant au moins partiellement coulé dans la matière de coulée (26) ; et l'au moins un actionneur (54) étant sur le côté arrière (36) de la carte de circuit imprimé (12) et comportant au moins deux ressorts de contact (56) qui sont pressés sur les au moins deux surfaces de contact (34) de sorte que la paroi de séparation (42) s'étende au moins partiellement entre les ressorts de contact (56).

2. Ensemble selon la revendication 1,
l'élément de protection contre les copeaux (30) faisant saillie de la matière de coulée (26) ; ou
l'élément de protection contre les copeaux (30) étant complètement recouvert sur le côté avant (38) par la matière de coulée (26).

3. Ensemble selon l'une des revendications précédentes,
la cavité (44) étant remplie d'une matière de coulée (26) .

4. Ensemble selon l'une des revendications précédentes,
l'élément de protection contre les copeaux (30) comportant une contre-dépouille (46) qui est décalée sur le côté arrière (36) de la carte de circuit imprimé (12) .

5. Ensemble selon l'une des revendications précédentes, l'élément de protection contre les copeaux (30) comportant une saillie (50) qui maintient l'élément de protection contre les copeaux (30) dans la matière de coulée (26).

6. Ensemble selon l'une des revendications précédentes,
l'élément de protection contre les copeaux (30) et l'ouverture (32) ménagée dans la carte de circuit imprimé (12) étant en forme de T pour chacune des deux surfaces de contact électrique (34).
